# DEMANDE DE BREVET EUROPEEN

(11) **EP 1 617 471 A1**
(43) Date de publication de la demande: **18.01.2006**
(21) Numéro de dépôt: 04405445.0
(22) Date de dépôt: 13.07.2004
(51) Int. Cl.: H01L 23/367, H01S 5/12, H01S 5/34

(54) **Dispositif a lasers semi-conducteurs**

(71) Demandeur: Alpes Lasers S.A., 2001 Neuchatel (CH)
(72) Inventeur: Hvozdara, Lubos, 2000 Neuchatel (CH); Müller, Antoine, 2000 Neuchatel (CH); Bonetti, Yargo, 2000 Neuchatel (CH)
(74) Mandataire: GLN

(57) **Abrégé**

Dispositif à laser semi-conducteur comportant :
- un substrat (10) assurant une fonction d'électrode inférieure,
- un empilement de couches (11) disposées sur le substrat (10) et dont la composition et l'épaisseur sont choisies de manière à ce qu'il puisse former un laser semi-conducteur à cascades quantiques, l'une desdites couches étant structurée en réseau de diffraction (23), une autre assurant la fonction d'électrode supérieure (16), et
- des moyens de liaison destinés à relier ladite électrode supérieure (16) et une source d'énergie extérieure.

Ce dispositif comporte en outre un deuxième empilement de couches (12) identiques dans leur épaisseur et dans leur composition à celles du premier empilement (11), ledit deuxième empilement (12) étant contigu au premier (11) et agencé de manière à pouvoir former un deuxième laser semi-conducteur à cascades quantiques.

## Description

La présente invention se rapporte aux lasers à semi-conducteur émettant dans une bande de longueurs d'onde comprise dans l'infrarouge, de type à cascades quantiques.

La présente invention concerne, plus particulièrement, un laser comportant, de manière connue, un substrat formant une électrode inférieure, et, sur celui-ci, un empilement de couches en matériaux semi-conducteurs qui forme un guide d'onde comprenant une région de gain et des régions de confinement inférieure et supérieure entre lesquelles est interposée la région de gain. La surface supérieure de la région de confinement supérieure forme un réseau optique destiné à sélectionner une longueur d'onde déterminée à l'intérieur de la bande de longueurs d'ondes émises dans la région de gain. Ce type de laser est appelé laser à 'réaction distribuée' de l'anglais 'Distributed Feedback' (DFB) laser. II est utilisé, par exemple, pour la spectroscopie d'absorption de gaz polluants.

Le fonctionnement des lasers à semi-conducteur à cascades quantiques est décrit dans un article de la revue Science, May 1997, Volume 75, pp 773-776, intitulé 'High Power Infrared Supperlattice Lasers'. Pour plus de détails relatifs aux lasers de type DFB, on se référera avantageusement au document US 5 901 168.

Ces lasers sont obtenus par une suite complexe d'étapes de dépot de couches sur un substrat mono-cristallin, et d'étapes de gravure chimique ou physico-chimique destinées à constituer le réseau de diffraction et structurer le laser. Dans une phase intermédiaire, ces lasers se présentent, sur le substrat mono-cristallin, sous la forme de 'barreaux' (en anglais 'ridges') de largeur environ 5 à 30µm, de hauteur environ 6µm, et s'étendant sur toute la longueur du substrat, c'est à dire plusieurs millimètres à quelques centimètres. Chaque 'barreau' est séparé de son voisin par un espace large d'environ 400 à 500µm nécessaire au 'bonding' du laser, c'est à dire à la soudure d'un fil électrique permettant l'application d'un signal de commande. La distance entre barreaux est en outre définie par une largeur choisie de manière telle que la manipulation en soit facilitée. De ce fait, le risque est plus faible d'endommager le laser par une fausse manipulation ou lors de l'opération de découpage des 'puces'. Ainsi, la densité des barreaux sur le substrat est limitée non pas par le procédé de fabrication des barreaux, mais par les étapes ultérieures de la fabrication et les nécessités de la manipulation.

Le substrat est ensuite clivé parallèlement et perpendiculairement aux barreaux, de façon à obtenir des 'puces' (en anglais 'chip') de longueur 1.5 à 3mm, de largeur 400 à 500µm, comportant chacune un barreau formant un laser, lequel est centré dans le sens de la largeur de la puce.

Le nombre et la complexité des opérations nécessaires à la fabrication des lasers DFB, ainsi que les spécifications exigées par les applications de ces lasers, sont tels que le rendement actuel pour la production se situe à un niveau relativement bas.

La présente invention a pour but de pallier cet inconvénient en proposant un dispositif laser à cascades quantiques permettant d'élever le rendement de fabrication en augmentant la densité des barreaux sur le substrat, sans pour autant compliquer la manipulation ou modifier le bonding.

Plus précisément, l'invention concerne un dispositif à laser semi-conducteur comportant :
- un substrat assurant une fonction d'électrode inférieure,
- un empilement de couches disposées sur le substrat et dont la composition et l'épaisseur sont choisies de manière à ce qu'il puisse former un laser semi-conducteur à cascades quantiques, l'une desdites couches étant structurée en réseau de diffraction, une autre assurant la fonction d'électrode supérieure, et
- des moyens de liaison destinés à relier ladite électrode supérieure et une source d'énergie extérieure.

Ce dispositif est caractérisé en ce qu'il comporte un deuxième empilement de couches identiques dans leur épaisseur et dans leur composition à celles du premier empilement, ledit deuxième empilement étant contigu au premier et agencé de manière à pouvoir former un deuxième laser semi-conducteur à cascades quantiques.

Afin de garantir une surface de la 'puce' aussi faible que possible, les deux empilements sont distants l'un de l'autre de moins de 100µm et typiquement de 50µm.

Dans une première variante, les deux barreaux sont identiques et parallèles entre eux, ce qui permet d'augmenter sensiblement la probabilité d'obtenir un laser fonctionnel ayant les caractéristiques voulues. Le dispositif présente donc encore les caractéristiques suivantes :
- les largeurs desdits empilements sont égales.
- lesdits empilements sont parallèles.
- les périodes desdits réseaux sont égales.

Par ailleurs, une application importante des lasers DFB étant la spectroscopie laser de gaz polluants, les lasers DFB sont conçus et fabriqués pour émettre à une longueur d'onde déterminée, signature du gaz recherché. Cependant, il peut s'avérer difficile d'émettre précisément à la longueur d'onde souhaitée, étant donné la complexité des procédés de fabrication et les inévitables imperfections du réseau. Pour pallier cet inconvénient, la présente invention propose un dispositif comportant deux lasers structurés de manière à émettre à deux longueurs d'ondes proches.

A cet effet, et dans cette variante, le dispositif est caractérisé en ce que les largeurs des empilements sont différentes, ce qui modifie légèrement l'indice de réfraction de l'empilement.

D'un autre côté, il peut être intéressant d'analyser deux gaz ayant des signatures différentes avec le même dispositif laser. Ceci peut être réalisé par la présente invention, qui propose un dispositif comportant deux lasers émettant à deux longueurs d'ondes radicalement différentes, grâce au fait que les réseaux des deux empilements ont des périodes différentes.

Par ailleurs, il peut être avantageux de faire fonctionner les deux lasers indépendamment l'un de l'autre ou solidairement, de manière à cumuler la puissance des deux lasers. L'invention présente donc encore l'une ou l'autre des deux caractéristiques suivantes :
- lesdits moyens de liaison comportent une couche de contact étendu recouvrant les deux empilements ;
- lesdits moyens de liaison comportent une première et une deuxième couche de contact étendu qui recouvrent respectivement le premier et le deuxième empilement.

Enfin, il peut s'avérer intéressant de faire converger les deux faisceaux laser en un point afin d'y concentrer leur puissance. Ceci peut être réalisé par l'invention qui propose un dispositif caractérisé en ce que lesdits empilements forment un angle aigu entre eux.

D'autres caractéristiques de l'invention ressortiront de la description qui va suivre, faite en regard du dessin annexé, dans lequel :
- les figures 1 à 3 représentent respectivement, vu en coupe transversale, en coupe longitudinale et en plan, un premier mode de réalisation d'un dispositif selon l'invention, avant découpe sur les figures 1 et 2, après découpe sur la figure 3, et
- la figure 4 est une vue de dessus d'un autre mode de réalisation d'une puce laser à semi-conducteur selon l'invention.

Sur ces figures, les échelles ne sont pas respectées, de manière à ce que les caractéristiques des empilements soient apparentes, malgré leur faible épaisseur.

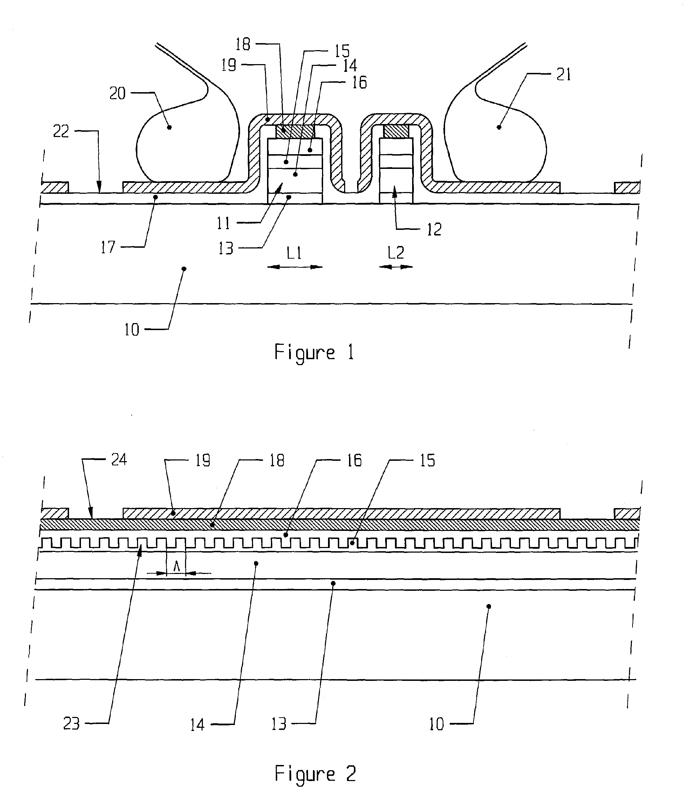

Les figures 1 à 3 représentent schématiquement un dispositif comportant deux lasers de type DFB disposés côte à côte sur une même puce. Il comporte classiquement un substrat mono-cristallin 10 commun, en matériau semi-conducteur, typiquement du phosphure d'indium, servant d'électrode inférieure et de support mécanique, et deux empilements de couches 11 et 12 adjacents, à section sensiblement trapézoïdale, distants de moins de 100µm, typiquement de 30µm, et de largeurs comprises entre 5 et 30µm. Dans le mode de réalisation représenté, les largeurs I₁ et I₂ respectivement des empilements 11 et 12 sont légèrement différentes, pour des raisons qui apparaîtront plus loin. Dans une variante non représentée, les largeurs des deux empilements pourraient être identiques.

Ces empilements de couches 11 et 12 en matériau semi-conducteur constituent la partie active du laser et comportent chacun, à partir du substrat 10, une couche de confinement inférieure 13, une région de gain 14, une couche de confinement supérieure 15 et une électrode supérieure 16.

La région de gain 14 est elle même constituée d'une pluralité de couches constituant des puits et des barrières quantiques, et formant une zone dans laquelle s'effectuent des transitions électroniques inter-sous-bandes. Plus précisément, les électrons transitant d'une électrode à l'autre passent dans cette région de gain 14 d'une sous-bande supérieure à une sous-bande inférieure et génèrent ainsi des photons. La lumière ainsi générée par effet laser est confinée dans le guide d'onde constitué de la couche de gain 14 et des couches de confinement inférieure 13 et supérieure 15.

Les flancs des empilements de couches 11 et 12 et la surface exposée du substrat 10 sont recouverts d'une couche de passivation électrique 17, avantageusement en nitrure de silicium ou en oxyde de silicium, débordant légèrement sur les faces supérieures des électrodes supérieures 16 et servant à éviter tout court-circuit entre les électrodes supérieure 16 et inférieure 10. La partie non passivée des électrodes supérieures 16 est recouverte d'une couche de contact métallique local 18.

Une couche de contact métallique étendu 19 destinée au 'bonding', c'est à dire au soudage d'un fil électrique, recouvre les flancs et la face supérieure des empilements 11 et 12. Elle s'interrompt sur une largeur d'environ 10µm entre les deux empilements 11 et 12 afin de pouvoir contacter l'un ou l'autre indépendamment, mais s'étend sur environ 200 à 250µm de part et d'autre de la paire d'empilements 11 et 12, sur la couche de passivation électrique 17. La largeur de cette zone de contact étendu est telle que, d'une part, elle permet le 'bonding' du dispositif et, d'autre part, facilite sa manipulation après découpe.

Autour de la couche de contact étendu 19, la couche de passivation 17 est apparente sur une largeur de quelque 30µm entre deux paires de DFB lasers voisins, formant ainsi une ligne de découpe longitudinale 22 destinée au clivage du substrat. La couche de passivation 17 recouvre totalement cette ligne de découpe 22, afin d'éviter tout court-circuit entre les électrodes en cas de problème d'alignement de la couche de contact étendu 19 par rapport à la couche de passivation 17.

Deux fils électriques 20 et 21 sont soudés à la couche de contact étendu 19, le premier contactant l'empilement 11, le second, l'empilement 12.

Comme représenté sur la figure 2, chacun des DFB lasers jumeaux se présente, avant découpe du substrat 10, sous la forme d'un barreau dont la longueur (typiquement 1.5 à 3mm) est grande devant la hauteur (environ 6µm) et de largeur comprise entre 5 et 30µm.

Un réseau optique en créneaux 23 de période A est pratiqué sur la face supérieure de la couche de confinement supérieure 15. Ce réseau est obtenu par holographie ou par un procédé de photolithographie bien connu de l'homme de métier, suivi d'une attaque chimique ou physico-chimique. Il est destiné à sélectionner une longueur d'onde λ dans la bande de longueurs d'ondes émises par le laser, une relation existant entre la longueur d'onde λ, la période du réseau A et l'indice de réfraction effectif n_{eff} de la région de gain 14.

Cet indice de réfraction effectif n_{eff} est lui même fonction de la largeur de l'empilement. Les empilements 11 et 12 étant de largeurs I₁ et I₂ légèrement différentes, ils présentent deux indices de réfraction effectifs, respectivement n_{1eff} et n_{2eff}, différents mais proches. Ainsi, les longueurs d'ondes λ1 et λ₂ émises par les empilements respectifs 11 et 12 sont légèrement décalées, ce qui permet d'augmenter la probabilité d'obtenir la longueur d'onde λ visée lors de la fabrication.

La couche de contact étendu 19 s'étend sur une longueur typique de 1.5mm, puis s'interrompt sur une zone de largeur quelque 30µm séparant deux lasers DFB consécutifs et formant une ligne de découpe transversale 24.

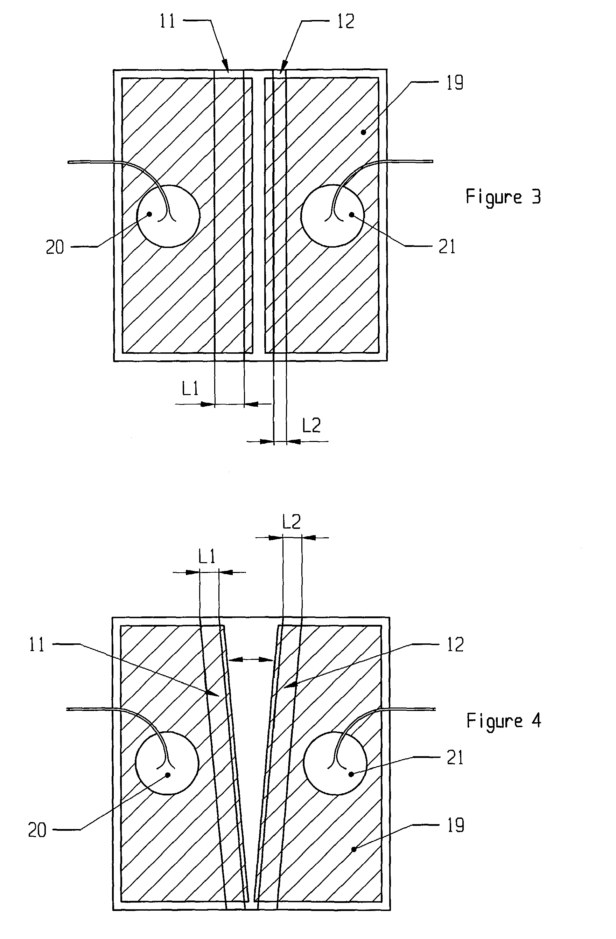

Les DFB lasers ainsi représentés sur les figures 1 et 2 sont produits en grand nombre sur un substrat 10 commun, puis sont séparés par clivage suivant les lignes de découpe longitudinales 22 et transversales 24. Au final, deux DFB lasers jumeaux se présentent sous la forme de deux barreaux de largeurs légèrement différentes, distants de moins de 100µm, et centrés sur une 'puce' de longueur 1.5 à 3mm et de largeur environ 500µm, comme représenté sur la figure 3, pour former un dispositif selon l'invention. Ces dimensions sont pratiquement les mêmes que celles d'un dispositif ne comportant qu'un seul barreau par puce, l'espace occupé par le second barreau étant négligeable en regard de la largeur de la puce. Cet arrangement permet donc, pour une même surface de substrat 10 utilisée par rapport à une configuration traditionnelle ne comportant qu'un seul barreau par puce, d'augmenter la probabilité de fabriquer une puce comportant au moins un empilement fonctionnel. Ceci représente un avantage considérable pour une technologie dont le rendement de fabrication se situe à un niveau relativement faible.

La couche de contact étendu 19 représentée sur la figure 3 est interrompue sur toute la longueur entre les deux empilements 11 et 12 afin de permettre une commande indépendante des deux lasers, mais dans une autre variante non représentée, la couche de contact étendu 19 pourrait être continue afin de faire fonctionner les deux empilements solidairement, par l'application d'un seul signal électrique.

Une autre variante non représentée consiste à graver sur les deux empilements 11 et 12 deux réseaux 23 de périodes respectives Λ₁ et Λ₂ différentes, permettant de sélectionner deux longueurs d'ondes λ₁ et λ₂ différentes. Cette solution, à la différence de la solution consistant à moduler la longueur d'onde émise par la largeur des empilements 11 et 12, permet d'obtenir deux longueurs d'ondes non pas proches, mais radicalement différentes. Cette variante n'est pas directement compatible avec un procédé de fabrication du réseau par holographie, mais plutôt avec un procédé de photolitographie employant deux masques différents pour les deux réseaux 23, ou avec un procédé d'écriture directe au moyen d'un faisceau d'électrons.

Dans une autre variante représentée sur la figure 4, les empilements 11 et 12 ne sont pas disposés parallèlement l'un à l'autre sur la puce, mais forment entre eux un angle α aigu typiquement inférieur ou égal à 15°. De la sorte, les rayonnements émis par les deux empilements 11 et 12 peuvent converger en un même point, ce qui permet d'additionner les puissances des deux lasers.

## Revendications

1. Dispositif à laser semi-conducteur comportant :
• un substrat (10) assurant une fonction d'électrode inférieure,
• un empilement de couches (11) disposées sur le substrat (10) et dont la composition et l'épaisseur sont choisies de manière à ce qu'il puisse former un laser semi-conducteur à cascades quantiques, l'une desdites couches étant structurée en réseau de diffraction (23), une autre assurant la fonction d'électrode supérieure (16), et
• des moyens de liaison destinés à relier ladite électrode supérieure (16) et une source d'énergie extérieure,
**caractérisé en ce qu'**il comporte un deuxième empilement de couches (12) identiques dans leur épaisseur et dans leur composition à celles du premier empilement (11), ledit deuxième empilement (12) étant contigu au premier (11) et agencé de manière à pouvoir former un deuxième laser semi-conducteur à cascades quantiques.

2. Dispositif selon la revendication 1, **caractérisé en ce que** lesdits empilements (11, 12) sont distants de moins de 100µm.

3. Dispositif selon l'une des revendications 1 et 2, **caractérisé en ce que** lesdits moyens de liaison comportent une couche de contact étendu (19) recouvrant les deux empilements (11, 12).

4. Dispositif selon l'une des revendications 1 à 2, **caractérisé en ce que** les moyens de liaison comportent une première et une deuxième couche de contact étendu (19) qui recouvrent respectivement le premier et le deuxième empilement (11, 12).

5. Dispositif selon l'une des revendications 1 à 4, **caractérisé en ce que** les largeurs (I₁, I₂) desdits empilements (11, 12) sont égales.

6. Dispositif selon l'une des revendications 1 à 4, **caractérisé en ce que** les largeurs (I₁, I₂) desdits empilements (11, 12) sont sensiblement différentes.

7. Dispositif selon l'une des revendications 1 à 6, **caractérisé en ce que** lesdits réseaux (23) ont des périodes égales.

8. Dispositif selon l'une des revendications 1 à 6, **caractérisé en ce que** lesdits réseaux (23) ont des périodes différentes.

9. Dispositif selon l'une des revendications 1 à 8, **caractérisé en ce que** lesdits empilements (11, 12) sont parallèles.

10. Dispositif selon l'une des revendications 1 à 8, **caractérisé en ce que** lesdits empilements (11, 12) forment un angle aigu entre eux.
